# EUROPÄISCHE PATENTANMELDUNG

(11) **EP 2 458 645 A1**
(43) Veröffentlichungstag der Anmeldung: **30.05.2012**
(21) Anmeldenummer: 11075207.8
(22) Anmeldetag: 06.09.2011
(51) Int. Cl.: H01L 31/048, H01R 13/58

(54) **Solarmodul mit einer Verbindungseinheit mit einem Formteil**

(30) Priorität: 29.11.2010 DE 102010053151
(71) Anmelder: SOLON SE, 12489 Berlin (DE)
(72) Erfinder: Purucker, Jan, 15745 Wildau (DE); Güttler, Patrick, 14542 Werder/Havel (DE)

(57) **Zusammenfassung**

Solarmodule weisen eine Verbindungseinheit mit einer elektrisch leitenden Verbindung zwischen einem dem elektrischen Anschluss des Solarmoduls dienenden Solarkabel und einem mehrere Solarzellen im Solarmodul elektrisch leitend miteinander verbindenden Leiterband auf. Dabei sind alle Solarzellen und Leiterbänder in ein biegsames Laminat luft- und wasserdicht eingeschlossen. Bei Verbiegungen des Laminats kann es zu Beschädigungen im Bereich der Verbindungseinheit kommen. Das Solarmodul (01) nach der Erfindung umfasst deshalb eine Verbindungseinheit (02), die ein biegsames Formteil (13) aufweist, das die elektrisch leitende Verbindung (08), einen Abschnitt (03) des Solarkabels (04) und einen weiteren Abschnitt (05) des Leiterbands (06), die jeweils an die elektrisch leitende Verbindung (08) anschließen, aufnimmt, und dass das Formteil (13) in das biegsame Laminat (09) formschlüssig eingeschlossen ist, wobei die Biegsamkeit des Formteils (13) an die Biegsamkeit des Laminats (09) angepasst ist. Durch das Laminat (09) ist das Formteil (13) gut abgedichtet und festgehalten, sodass es auch als Zugentlastung für die Solarkabel (04) wirkt. Vorteilhaft kann das Formteil (13) in Verbindungskomponenten (23, 28) noch die Solarkabel, die elektrisch leitende Verbindung (08) und einen Leiterbandkontakt (29) mitumfassen. Vorteilhaft ist das Solarmodul (01) als flexibles Solarmodul (40) mit Dünnschichtsolarzellen (32) ausgeführt.

## Beschreibung

Die Erfindung bezieht sich auf ein Solarmodul mit zumindest einer Verbindungseinheit mit zumindest einer elektrisch leitenden Verbindung zwischen einem dem elektrischen Anschluss des Solarmoduls dienenden Solarkabel und einem mehrere Solarzellen im Solarmodul elektrisch leitend miteinander verbindenden Leiterband, wobei die Solarzellen und das Leiterband in ein biegsames Laminat eingeschlossen sind.

Solarmodule bestehen aus einer Vielzahl von Solarzellen, deren Kontakte mittels Zellverbindern in Reihe geschaltet werden. Mehrere Reihen von Solarzellen werden dann in der Regel mittels Querverbindern elektrisch leitend verbunden, sodass das Solarmodul eine verwertbare Ausgangsspannung bzw. einen verwertbaren Ausgangsstrom zur Verfügung stellen kann. Zellverbinder und Querverbinder können auch als Leiterband bezeichnet werden. Der Anschluss eines Solarmoduls an den Verbraucher oder an weitere Solarmodule erfolgt über zwei Solarkabel. Jedes Solarkabel ist mit einem Leiterband über eine elektrisch leitende Verbindung kontaktiert, sodass der Stromkreis geschlossen ist und Strom bei Sonneneinfall in den Solarzellen fließen kann. Die elektrische Verbindung zwischen Solarkabel und Leiterband erfolgt in einer Verbindungseinheit. Dabei kommt der Verbindungseinheit neben der Funktion der Kontaktierung auch immer die Aufgabe der Zugentlastung von Solarkabeln und Leiterbändern zu, damit die elektrisch leitenden Verbindungen auch sicher halten. Üblicherweise weist ein Solarmodul genau eine Verbindungseinheit auf, in der zwei Solarkabel mit zwei Leitungsbändern elektrisch leitend verbunden sind. Nach Art und Anwendung des Solarmoduls kann dieses eine Verbindungseinheit (bevorzugt) oder zwei an unterschiedlichen Stellen positionierte Verbindungseinheiten aufweisen. Diese sind in der Regel zweipolig aufgebaut (elektrisch leitende Pluspol-Verbindung Solarkabel-Leiterband und elektrisch leitende Minuspol-Verbindung Solarkabel-Leiterband), können aber auch einpolig (Pluspol oder Minuspol) aufgebaut sein.

### STAND DER TECHNIK

Aus der DE 10 2007 052 722 A1 ist ein laminiertes Solarmodul bekannt, bei dem Verbindungseinheiten in Form von biegesteifen Anschlussdosen in einen das Solarmodul einfassenden Rahmen elektrisch isoliert integriert sind. Dabei dient der Rahmen aber insbesondere auch der Erhöhung der Biegesteifigkeit des Solarmoduls, sodass die Verbindungseinheiten keinen Verbiegungen unterworfen sind. Aus der DE 10 2007 023 210 B3 ist ebenfalls eine biegesteife Anschlussdose für Solarmodule bekannt, die mit einem Grundkörper auf das Solarmodul aufgeklebt wird. Die Solarkabel sind durch Anspritzen des Gehäuses fest mit der Anschlussdose verbunden. Die Leiterbänder werden von unten in die Anschlussdose eingeführt. Aus der DE 10 2009 053 018 A1 ist außerdem eine biegesteife Anschlussdose bekannt, bei der ein Anschlusspin in den Dosenboden eingegossen ist. Die Anschlussdose selbst wird auf ein Solarpaneel aufgeklebt. Insbesondere bei flexiblen im Sinne von biegsamen Solarmodulen ergeben sich bei der Ausgestaltung der Verbindungseinheit und insbesondere bei deren Anschluss an das biegsame Solarmodul immer wieder Probleme. Im Zusammenhang mit der vorliegenden Anmeldung wird der Begriff "Biegsamkeit" im Sinne von Flexibilität mit einer reversiblen Formanpassung verstanden. Somit ist Biegsamkeit auch mit idealer Elastizität gleichzusetzen, mit der die Eigenschaft eines Körpers beschrieben wird, unter Krafteinwirkung seine Form zu verändern und bei Wegfall der einwirkenden Kraft wieder in seine Ursprungsform zurückzukehren. Der Begriff "Biegsamkeit" erschien für die vorliegende Erfindung als der treffendste, da er unmittelbar den Unterschied zu dem Begriff "biegesteif" aufzeigt.

Der der Erfindung nächstliegende Stand der Technik wird in der DE 10 2009 039 370 A1 offenbart. Es wird ein Solarmodul mit Solarzellen und Leiterbändern beschrieben, die in ein biegsames Laminat eingeschlossen sind. Die vorgesehene Anschlusseinheit in Form einer Anschlussdose ist mehrteilig ausgebildet und besteht aus einem Querverbinder, einem Sockel und einem Gehäuse. Das Gehäuse weist Kabelanschlüsse zur Verbindung mit den Solarkabeln auf. Dabei übernehmen die Kabelanschlüsse die Funktion der Zugentlastung der Verbindungseinheit gegenüber den Solarkabeln. Weiterhin weist der Sockel Verbindungselemente zur Herstellung von elektrisch leitenden Verbindungen zwischen den Leiterbändern bzw. dem Querverbinder und den Solarkabeln auf. Der Querverbinder ist als Flachbaustein ausgebildet, in den zumindest zwei Enden von Leiterbändern eingegossen und durch Öffnungen zur Oberseite hin durch einen Sockel kontaktierbar sind. Der Flachbaustein ist auf einer ersten Laminatfolie angeordnet, auf der auch die Solarzellen und die Leiterbänder angeordnet sind. Der Flachbaustein wird aber nicht, wie die Solarzellen und die Leiterbänder, durch eine weitere Laminatfolie in das Laminat eingeschlossen. Vielmehr weist die weitere Laminatfolie im Bereich des Flachbausteins eine Aussparung auf, sodass der Flachbaustein im Laminat von oben zugänglich bleibt, dort mit dem Sockel verbunden ist und darüber von dem Gehäuse abgeschlossen wird. Dabei wird das Gehäuse gegenüber der ersten Laminatfolie abgedichtet. Die Biegsamkeit des Laminats wird durch eine vorgesehene Glasscheibe weitgehend kompensiert, trotzdem können sich insbesondere während der Herstellung, des Transports und der Montage der Solarmodule Verschiebungen zwischen dem biegsamen Laminat und der starren Verbindungseinheit und dadurch hervorgerufene Beschädigungen am Laminat oder Undichtigkeiten an der Verbindungseinheit ergeben.

### AUFGABENSTELLUNG

Die **AUFGABE** für die vorliegende Erfindung ist daher darin zu sehen, das gattungsgemäße Solarmodul der eingangs beschriebenen Art im Bereich seiner Verbindungseinheiten so weiterzubilden, dass zuverlässig zu keinem Zeitpunkt in der Lebensdauer des Solarmoduls Beschädigungen am biegsamen Laminat oder Undichtigkeiten an der Verbindungseinheit auftreten. Die erfindungsgemäße **LÖSUNG** für diese Aufgabe ist dem Hauptanspruch zu entnehmen. Vorteilhafte Weiterbildungen der Erfindung werden in den Unteransprüchen aufgezeigt und im Folgenden im Zusammenhang mit der Erfindung näher erläutert.

Bei dem gattungsgemäßen Solarmodul weist erfindungsgemäß die Verbindungseinheit ein biegsames Formteil auf, das die zumindest eine elektrisch leitende Verbindung, einen Abschnitt des Solarkabels und einen weiteren Abschnitt des Leiterband, die jeweils an die zumindest eine elektrisch leitende Verbindung anschließen, aufnimmt. Dabei ist die Biegsamkeit des Formteils an die Biegsamkeit des Laminats angepasst, das heißt, Biegungen, denen das Laminat unterworfen wird, können in gleichem Maße auch von dem Formteil ausgeführt werden. Laminat und Formteil sind gleichermaßen biegsam. Außerdem ist das Formteil erfindungsgemäß in das Laminat formschlüssig eingeschlossen. Durch die Biegsamkeit des einlaminierten Formteils sind Beschädigungen, beispielsweise Risse, Verschiebungen oder Brüche, sowohl am Laminat bzw. den Solarzellen und Leiterbändern als auch an der Verbindungseinheit vermieden. Das Solarmodul kann also insbesondere transportiert und montiert werden, ohne dass dabei auftretende Verbiegungen des Solarmoduls Schäden im Bereich der Verbindungseinheit hervorrufen können. Bekannte Verbindungseinheiten sind biegesteif und brechen ggfs. bei Biegungen des Solarmoduls. Durch den Einschluss in das Laminat bestehen für die feuchtigkeitsempfindliche Verbindungseinheit keine Dichtungsprobleme mehr. Aufwändige Dichtelemente sind vermieden. Weiterhin ist die Verbindungseinheit durch das elektrisch isolierende Laminat sicher gegen die Umwelt elektrisch isoliert. Auch wird über das in das Laminat formschlüssig eingeschlossene und damit gut verankerte Formteil eine gute Zugentlastung der Verbindungseinheit von den Solarkabeln, die dem externen Anschluss des Solarmoduls dienen, erreicht. Weiterhin können durch die Integration der Verbindungseinheit bzw. des Formteils in den Laminierprozess zusätzliche Arbeitsschritte, wie beispielsweise Setzen und Abdichten von Anschlussdosen außerhalb des Laminats, eingespart werden. Neben einer Vereinfachung des Herstellungsprozesses ergibt sich auch eine Verringerung der Prozesszeit durch geringe Standzeiten insbesondere für Vergusskleber.

Bevorzugt weist das Formteil eine ebene Unterseite als Auflagefläche im Solarmodul auf. Dadurch kann das Formteil einfach auf dieselbe Laminatfolie (oder auf eine Modulfolie auf der Laminatfolie) aufgelegt werden, auf die auch die Solarzellen und die Leiterbänder aufgelegt werden. Zur besseren Fixierung kann auf der ebenen Unterseite des Formteils vorteilhaft eine Klebeschicht oder eine Laminierschicht vorgesehen sein. Durch die Klebeschicht kann eine sichere Fixierung des Formteils vor der Fixierung erreicht werden, Durch die Laminierschicht kann sichergestellt werden, dass das Formteil zuverlässig einlaminiert wird, insbesondere auch dann, wenn die obere und die untere Laminierschicht sich nicht treffen, sondern am Rand des Solarmoduls enden und die Kantendichtung von einem Rahmenelement übernommen wird. Insbesondere die Durchführungen der Solarkabel stellen mögliche Undichtigkeitsstellen für das Solarmodul dar. Diese sind sicher vermieden, wenn das Formteil im Bereich der Nuten eine Laminierschicht aufweist, die beim Aufschmelzen mit der unteren Laminierfolie eine innige Verbindung eingeht. Nach der elektrischen Kontaktierung der Verbindungseinheit mit den Leiterbändern wird dann über alle Elemente eine weitere Laminatfolie gelegt. In einem einzigen Arbeitsschritt verschweißen die beiden Laminatfolien dann unter Hitzeinwirkung miteinander und schließen alle zwischengelegten Elemente staub- und wasserdicht ein.

Die Verbindungseinheit bei der Erfindung kann bevorzugt in drei verschiedenen Ausführungsformen ausgeführt werden. In der ersten Ausführungsform wird es vorteilhaft bevorzugt, wenn das Formteil eine ebene Unterseite hat und in dieser zumindest eine eingearbeitete Nut aufweist, in die die zumindest eine elektrisch leitende Verbindung, der Abschnitt des Solarkabels und der Abschnitt des Leiterbands eingelegt sind. Durch das Laminieren wird das Formteil dann gegen das Solarmodul gedrückt, sodass Solarkabel und Leiterband sicher gehalten werden. Die eingearbeitete Nut kann genau die Breite und Dicke von Solarkabel und Leiterband aufweisen. Im Bereich des Leiterbands kann die Nut aber auch breiter sein, sodass mehrere Leiterbänder in einer gemeinsamen Nut aufgenommen werden können. Sind Solarkabel und Leiterband bündig in das Formteil eingelegt, kann dieses mit seiner ebenen Unterseite auch bündig auf dem Untergrund aufliegen und das Solarkabel gut fixieren. Das Formteil hat also in der Verbindungseinheit insbesondere in der ersten Ausführungsform die Funktionen eines Gehäuses und einer Zugentlastung. Solarkabel, Leiterband und die zumindest eine elektrisch leitende Verbindung sind auf einer Modulfolie bzw. auf einer Laminatfolie angeordnet und werden von dem Formteil überspannt und durch die gemeinsame Laminierung sicher fixiert. Die zumindest eine elektrische Verbindung zwischen Solarkabel und Leiterband wird vor dem Auflegen des Formteils hergestellt. Beim Aufbringen der zweiten Laminatfolie werden alle Elemente dann staubund wasserdicht eingeschweißt. Da dem Formteil in der Verbindungseinheit im Zusammenwirken mit der formschlüssigen mechanischen Verbindung mit dem Laminat auch die Aufgabe der Zugentlastung zufällt, ist es vorteilhaft, wenn die Solarkabel besonders festgehalten und damit gegen Herausrutschen gesichert werden. Dies kann vorteilhaft dadurch erreicht werden, dass das Formteil im Bereich des Solarkabels in die Nut hineinragende Niederhalter aufweist, mit denen das Solarkabel auf das Solarmodul gedrückt wird. Bevorzugt kann es sich bei den Niederhaltern um quer zu der Nut verlaufende Rippen handeln, durch die der Anspressdruck auf das Solarkabel gegen das Solarmodul noch erhöht wird.

In einer zweiten bevorzugten vorteilhaften Ausführungsform der Verbindungseinheit umfasst das Formteil auf einer Seite den Abschnitt des Solarkabels und sichert es damit gegen Herausrutschen.. Damit bilden das Formteil und das Solarkabel zusammen eine gemeinsame Verbindungskomponente, die entsprechend vorgefertigt zur Verfügung gestellt werden und den Montagevorgang am Solarmodul vereinfachen kann. Durch die gegen Herausrutschen gesicherte mechanische Verbindung zwischen Solarkabel und Formteil ist eine gute Zugentlastung gewährleistet. Auf seiner anderen Seite weist das Formteil weiterhin eine ebene Unterseite auf, in die zumindest eine Nut eingearbeitet ist, in die der Abschnitt des Leiterbands eingelegt ist. Die gemeinsame Verbindungskomponente aus Formteil und Solarkabel wird also bei der Montage entsprechend auf das Leiterband aufgesetzt. Damit nach dem Aufsetzen des Formteils zwischen dem Solarkabel und dem Leiterband die zumindest eine elektrisch leitende Verbindung hergestellt werden kann, weist das Formteil einen Hohlraum auf, der von einer Oberseite des Formteils her zugänglich ist und sich bis zur Unterseite des Formteils erstreckt. In diesem Hohlraum im Formteil ist die zumindest eine elektrisch leitende Verbindung dann angeordnet. Bevorzugt kann der Hohlraum auf der Oberseite des Formteils von einer Abdeckung abgeschlossen sein, die vom Laminat abgedeckt ist. Das Laminat übernimmt also wiederum die Dichtfunktion. Für den Fall, dass im montierten Zustand des Solarmoduls der Hohlraum zugänglich gemacht werden muss, kann aber die einlaminierte Abdeckung entfernt und anschließend wieder dichtend eingeklebt werden.

In einer dritten bevorzugten vorteilhaften Ausführungsform der Verbindungseinheit umfasst das Formteil bevorzugt den Abschnitt des Solarkabels, die zumindest elektrisch leitende Verbindung und einen Leiterbandkontakt. Damit bilden das Formteil, das Solarkabel und der Leiterbandkontakt zusammen ebenfalls eine gemeinsame Verbindungskomponente. Nunmehr enthält diese neben dem Solarkabel auch die zumindest eine elektrisch leitende Verbindung zwischen dem Solarkabel und einem Leiterbandkontakt und den Leiterbandkontakt. Durch die gegen Herausrutschen gesicherte feste mechanische Verbindung zwischen Solarkabel und Formteil ist auch bei dieser Ausführungsform eine gute Zugentlastung gewährleistet. Es existiert kein Hohlraum im Inneren des Formteils. Die elektrische Verbindung an das Solarkabel ist vorgefertigt und sicher im Formteil eingeschlossen. Auch diese Verbindungskomponente kann vorgefertigt werden und erleichtert damit den Montagevorgang des Solarmoduls.

Der in das Formteil integrierte Leiterbandkontakt kann bevorzugt ein zusätzlicher Leiterbandabschnitt sein, der über die ebene Unterseite aus dem Formteil herausgeführt und dann mit dem Leiterband auf dem Solarmodul elektrisch leitend verbunden wird. Dabei ist die elektrische leitende Verbindung dieses zusätzlichen Leiterbandsabschnitts mit dem Leiterband im Solarmodul erheblich einfacher herzustellen als die elektrische leitende Verbindung des Leiterbands mit dem Solarkabel. Hier sind Kontakte erforderlich, die die Leitungen mit rundem Querschnitt im Solarkabel mit dem flachen Profil des Leiterbands verbinden. Diese zumindest eine elektrisch leitende Verbindung ist aber bereits in der gemeinsamen Verbindungskomponente enthalten und damit extern vorgefertigt. Der aus der Unterseite des Formteils herausragende zusätzliche Leiterbandabschnitt kann noch durch die Modulfolie, auf der die Solarzellen angeordnet sind, hindurch gezogen und dann mit dem Leiterband durch einfaches Löten, Kleben oder durch eine kalte Klemmverbindung elektrisch leitend verbunden werden. Er kann aber auch oberhalb der Modulfolie kontaktiert werden, was im Einzelnen von den vorgegebenen Platzund Geometrieverhältnissen im Solarmodul abhängt. Alternativ kann der Leiterbandkontakt auch als Kontaktplatte ausgebildet sein, die in der ebenen Unterseite des Formteils angeordnet ist und Schneid- oder Federkontakte zur Kontaktierung mit dem Leiterband aufweist. Eine derartige kalte Kontaktierung ist durch einfaches Aufstellen des Formteils besonders leicht herstellbar. Auch hier kann das Leiterband entweder wieder unterhalb der Modulfolie kontaktiert sein, dann weist diese an der entsprechenden Stelle eine Öffnung auf, oder die Schneidkontakte durchdringen die Modulfolie. Eine Kontaktierung oberhalb der Modulfolie ist ebenfalls wiederum möglich. In beiden Alternativen kann sich die Kontaktierung mit dem Leiterband bevorzugt unterhalb des Formteils befinden, sodass sie durch das Formteil oder eine sich auf seiner Unterseite befindende Laminierschicht zuverlässig innerhalb des Laminats ebenfalls geschützt und abgedichtet ist. Befindet sich die Kontaktierung außerhalb des Formteils, muss darauf geachtet werden, dass sie ebenfalls zuverlässig in das Laminat eingedichtet ist.

Erfindungsgemäß ist das Formteil formschlüssig einlaminiert. Dabei ist es vorteilhaft, wenn das Formteil flach, d.h. mit nur einer geringen Bauhöhe, ausgebildet ist und gut in das Laminat, das ebenfalls nur eine geringe Bauhöhe aufweist, eingeschlossen werden kann. Weiterhin ist es bei allen Ausführungsformen des Formteils vorteilhaft, wenn das Formteil eine erste Stirnseite aufweist, über die das Solarkabel aus dem Formteil herausgeführt und mit der es am Rand der Solarmoduls angeordnet ist. Durch ist sicher gewährleistet, dass das freie Solarkabel nicht in das Laminat miteingebunden ist, sondern frei in den Raum abgeht. Für eine gute formschlüssige Einlaminierung des Formteils ist es weiterhin vorteilhaft, wenn das Formteil eine zweite Stirnseite mit einer Abschrägung aufweist. Weiterhin ist es vorteilhaft, wenn die Oberseite des Formteils eine Rundung und/oder quer zum Solarkabel verlaufende Rillen aufweist. Durch die Rundung kann wiederum eine saubere Laminierung ohne Einschluss von Luft und ohne Gefahr von Rissbildung an scharfen Kanten erreicht werden. Durch die quer verlaufenden Rillen kann eine besonders gute Haftung des Formteils zusätzlich durch Formschluss im Laminat erreicht werden. Außerdem verbessern die Rillen in Abhängigkeit von ihrer Tiefe die Biegsamkeit des Formteils. Derartige Formgebungen lassen sich besonders einfach herstellen, wenn vorteilhaft das Formteil als einstückiges Spritzgussteil aus einem Kunststoff ausgebildet ist.

Bereits eingangs wurde erwähnt, dass je nach Anforderungen ein oder zwei Verbindungseinheiten auf dem Solarmodul vorgesehen sein können. Bevorzugt ist aber die Ausbildungsform, bei der genau eine Verbindungseinheit mit zwei elektrisch leitenden Verbindungen zwischen jeweils einem Solarkabel und einem Leiterband vorgesehen ist. Weiterhin eignet sich die beschriebene Verbindungseinheit mit dem flexiblen, einlaminierten Formteil besonders für flexible (also biegsame) Solarmodule, bei denen die Solarzellen als Dünnschichtsolarzellen ausgebildet sind. Hierbei kann es sich beispielsweise um flexible Solarmodule handelt, die auf Dachbahnen auflaminiert sind. Der Transport erfolgt dann in aufgerollter Form. Durch Anwendung der Erfindung kommt es hierbei nicht zu Beschädigungen im Bereich der Verbindungseinheit.

Neben seiner direkten Integration des beschrieben Formteils in die Verbindungseinheit auf einem Solarmodul und damit Zuverfügungstellung des Formteils nur im Rahmen des gesamten Solarmoduls kann das Formteil insbesondere in seinen drei verschiedenen Ausführungsformen als Zugentlastung (erste Ausführungsvariante), als Verbindungskomponente mit dem Solarkabel oder (zweite Ausführungsvariante) oder als Verbindungskomponente mit dem Solarkabel, der elektrisch leitenden Verbindung mit dem Solarkabel und einem Kontaktstück zur einfachen Kontaktierung des Leiterbands auf dem Solarmodul (dritte Ausführungsvariante) als vorgefertigte Baugruppe zur besonders einfachen Integration in ein beliebiges gattungsgemäßes Solarmodul zur Verfügung gestellt werden. Weitere Details zur Erfindung sind den nachfolgend beschrieben Ausführungsbeispielen zu entnehmen.

### AUSFÜHRUNGSBEISPIELE

Bevorzugte Ausbildungsformen des Solarmoduls mit einer Verbindungseinheit mit einem Formteil nach der Erfindung werden nachfolgend anhand der nicht maßstabsgerechten, schematischen Figuren näher erläutert. Dabei zeigen
- **FIGUR 1**: einen Querschnitt des Solarmoduls,
- **FIGUR 2A, B**: eine perspektivische Ansicht des Formteils in einer ersten Ausführungsvariante,
- **FIGUR 3**: eine perspektivische Ansicht des Formteils in einer zweiten Ausführungsvariante,
- **FIGUREN 4A, B**: zwei Querschnitt des Solarmoduls mit dem Formteil in einer dritten Ausführungsvariante und
- **FIGUR 5**: eine perspektivische Ansicht auf das Solarmodul.

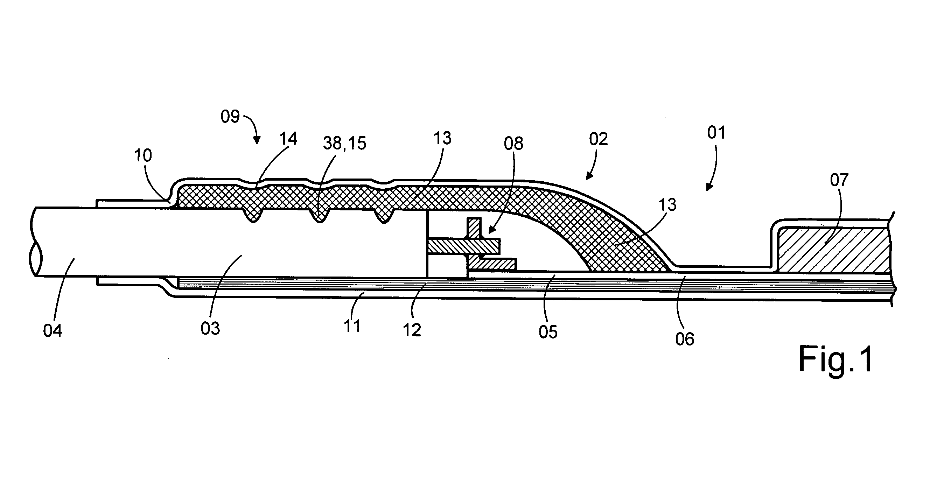

Die **FIGUR 1** zeigt im Querschnitt ein Solarmodul **01** mit einer Verbindungseinheit **02**. Die Verbindungseinheit **02** umfasst einen Abschnitt **03** eines Solarkabels **04,** einen weiteren Abschnitt **05** eines Leiterbands **06** (Ausführung als Zellverbinder oder einen Querverbinder, das mehrere Solarzellen **07** im Solarmodul **01** elektrisch leitend miteinander verbindet und eine elektrisch leitende Verbindung **08** zwischen dem Abschnitt **03** des Solarkabel **04** und dem weiteren Abschnitt **05** des Leiterbands **06**. Alle Elemente sind in ein biegsames Laminat **09** luft- und wasserdicht eingeschlossen. Das Laminat **09** besteht im gezeigten Ausführungsbeispiel aus einer oberen Laminatfolie **10** und einer unteren Laminatfolie **11,** die im Randbereich des Solarmoduls **01** miteinander verschweißt sind. Da eine derartige direkte Verbindung in der Regel aber relativ schwierig zu realisieren ist, insbesondere im Bereich der Solarkabel **04,** können die untere Laminatfolie 11 und die obere Laminatfolie **10** auch am Rand des Solarmoduls 01 enden. Die luft- und wasserdichte Verbindung wird dann von einem umlaufenden Rahmenelement übernommen (in der **FIGUR 1** nicht dargestellt). Auf der unteren Laminatfolie **11** befindet sich eine Modulfolie **12,** auf der die Solarzellen **07** und die Leiterbänder **06** angeordnet sind.

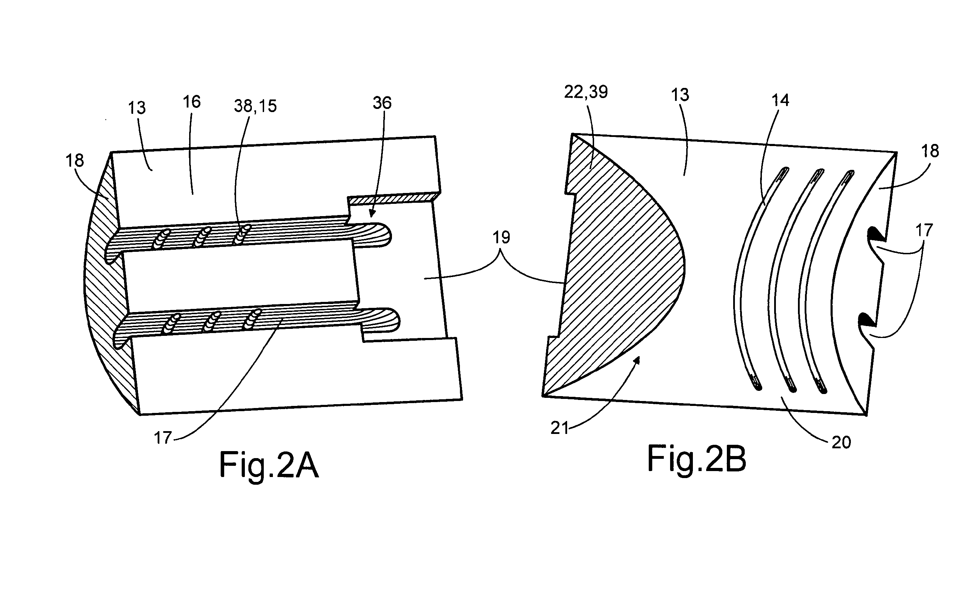

Die Verbindungseinheit **02** weist ein biegsames Formteil **13** auf, das die elektrisch leitende Verbindung **08,** den Abschnitt **03** des Solarkabels **04** und den weiteren Abschnitt **05** des Leiterbands **06** aufnimmt. Das biegsame Formteil **13** besteht beispielsweise aus einem Kunststoff und kann in einfacher Weise durch Formgießen hergestellt werden. Es ist in das biegsame Laminat **09** formschlüssig eingeschlossen, wobei die Biegsamkeit das Formteils **13** der Biegsamkeit des Laminats **09** entspricht, sodass beide Elemente unter Biegeeinfluss dieselben Biegungen ausführen können und sich nicht voneinander trennen oder beschädigt werden. Dabei ist die flache Ausbildung des Formteils **13** von besonderem Vorteil. Die Einschließung des Formteils **13** in das Laminat **09** sorgt bereits für einen guten Kraftschluss. Dieser wird durch den Formschluss zwischen **Formteil 13** und Laminat **09** noch erhöht. Der Formschluss wird noch weiter erhöht durch Rillen **14**, die sich in der Oberseite des Formteils **13** befinden. Außerdem verbessern die Rillen **14** in Abhängigkeit von ihrer Tiefe und Ausformung noch die Biegsamkeit des Formteils **13**, die neben dem Material auch durch seine Formgebung erreicht wird und an die Biegsamkeit des Solarmoduls **01** angepasst werden kann. Weiterhin weist das Formteil **13** Niederhalter **38** in Form von Rippen **15** auf, mit denen es den Abschnitt **03** des Solarkabels **04** auf die Modulfolie **12** niederdrückt und gut von möglichem Zug auf das Solarkabel **04** entlastet. Weiterhin weist das Formteil **13** eine ebene Unterseite **16** (siehe **FIGUR 2A****)** als Auflagefläche im Solarmodul **01**, hier auf der Modulfolie **12** auf.

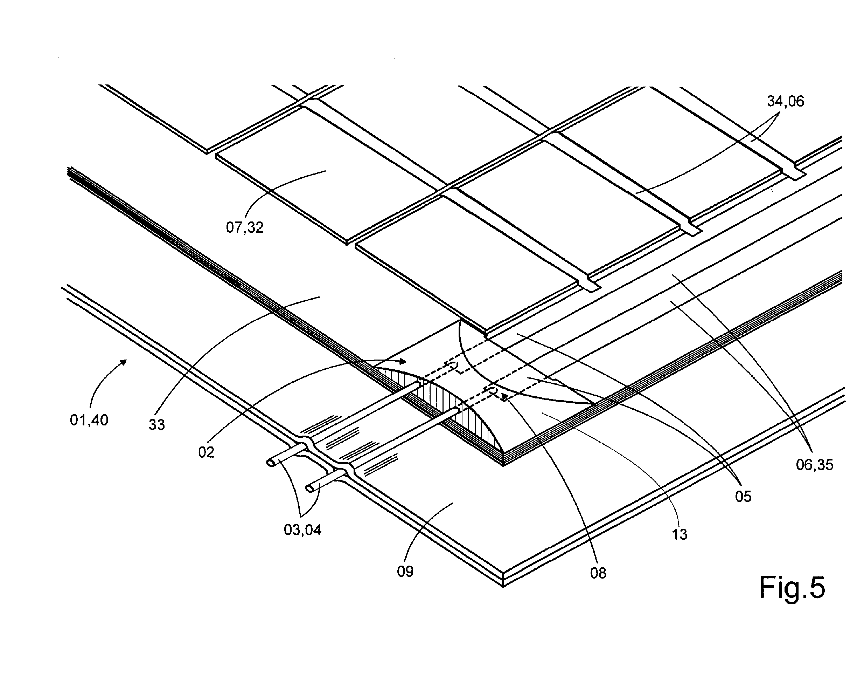

In den **FIGUREN 2A**, **2B** ist das Formteil **13** perspektivisch von unten **(****FIGUR 2A****)** und von oben **(****FIGUR 2B****)** dargestellt. In der **FIGUR 2A** ist die ebene Unterseite **16** zu erkennen. In dieser befinden sich im gewählten Ausführungsbeispiel zwei eingearbeitete Nuten **17**, in die jeweils ein Abschnitt **03** eines Solarkabels **04** einpassbar ist (siehe **FIGUR 1**). Innerhalb der Nuten **17** verlaufen Niederhalter **38**, gezeigt in der Ausführungsform der Rippen **15**. Die Abschnitte **03** der Solarkabel **04** werden durch eine erste Stirnseite **18** des Formteils **13** aus diesem herausgeführt. Beide Nuten **17** erweitern sich zu einer gemeinsamen Nut **19**, in die die elektrisch leitende Verbindung **08** und zwei Abschnitte **05** von zwei Leiterbändern **06** (siehe **FIGUR 1**) eingepasst werden. Zu erkennen ist ein kontinuierlicher Übergang **36** zwischen den Nuten **17** und der gemeinsamen Nut **19**. Alle Nuten **17, 19** sind so ausgeführt, dass nach Einpassen des Abschnitts **03** der Solarkabel **04**, der elektrisch leitenden Verbindung **08** und den beiden Abschnitten **05** der zwei Leiterbänder **06** das Formteil **13** mit seiner ebenen Unterseite **16** bündig auf der Modulfolie **12** aufliegen kann. In der **FIGUR 2B** ist eine Oberseite **20** des Formteils **13** zu erkennen, die eine Rundung **21** aufweist. Weiterhin ist eine zweite Stirnseite **22** des Formteils **13** dargestellt, die mit Abschrägungen **39** verläuft und in der die gemeinsame Nut **19** zu erkennen ist. Auch die Rillen **14** in der Oberseite **20** sind dargestellt. Die Nuten **17** enden in der ersten Stirnseite **18**, die senkrecht verläuft und an einer Kante des Solarmoduls **01** angeordnet sein kann, sodass die Solarkabel **04** ins freie verlaufen (vergleiche **FIGUR 5**).

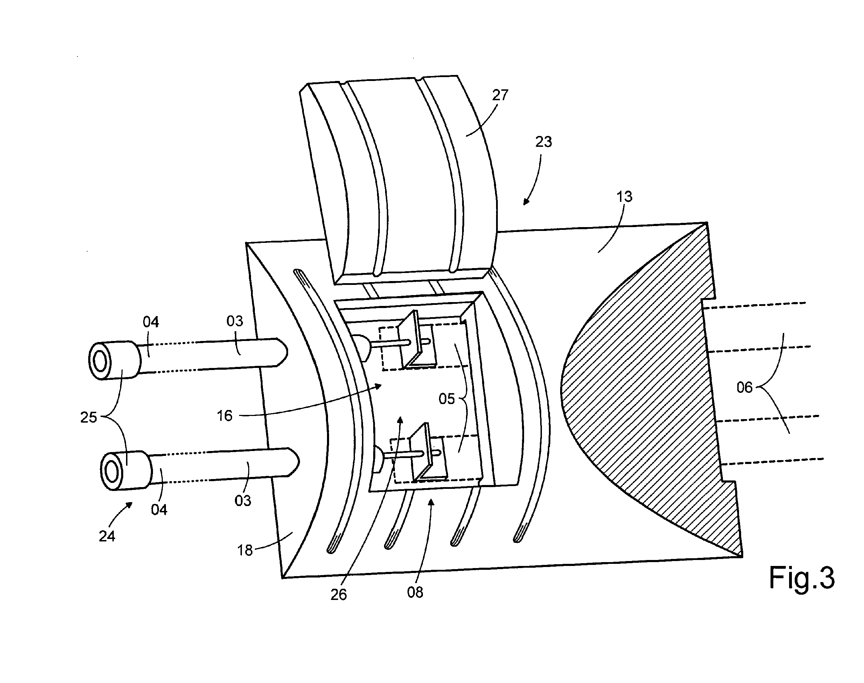

Die **FIGUR 3** zeigt in der perspektivischen Draufsicht das Formteil **13** in einer dauerhaften Verbindung mit den Solarkabeln **04** als erste gemeinsame Verbindungskomponente **23**. Auf der einen Seite umschließt das Formteil **13** die Abschnitte **03** von zwei Solarkabeln **04** dauerhaft und fest. Diese sind in die erste Stirnseite **18** integriert und treten durch diese ins Freie. Für den Anschluss an ein nächstes Bauelement, beispielsweise einen Gleich- oder Wechselrichter, eine Batterie, ein weiteres Solarmodul **01** oder den Verbraucher, weisen die Solarkabel **04** an ihren vom Formteil **13** abgewandten Enden **24** Stecker **25** auf. Das Formteil **13** weist weiterhin einen Hohlraum **26** auf, der sich von der Oberseite **20** des Formteils **13** bis zu seiner Unterseite **16** erstreckt. In diesem Hohlraum **26** kann nach Aufsetzen des Formteils 13 auf die Modulfolie **12** die elektrisch leitende Verbindung **08** mit den Leiterbändern **06** (in der **FIGUR 3** gestrichelt dargestellt) hergestellt werden. Weiterhin ist in der **FIGUR 3** eine Abdeckung **27** dargestellt, die nach der Herstellung der elektrisch leitenden Verbindung **08** und vor der Laminierung in den Hohlraum **26** eingepasst wird. Nach der Laminierung ist der Hohlraum **26** dann dicht abgeschlossen, aber nicht vom Laminat **09** ausgefüllt, sodass der Hohlraum **26** bei Bedarf durch Entfernen der Abdeckung **27** zugänglich bleibt.

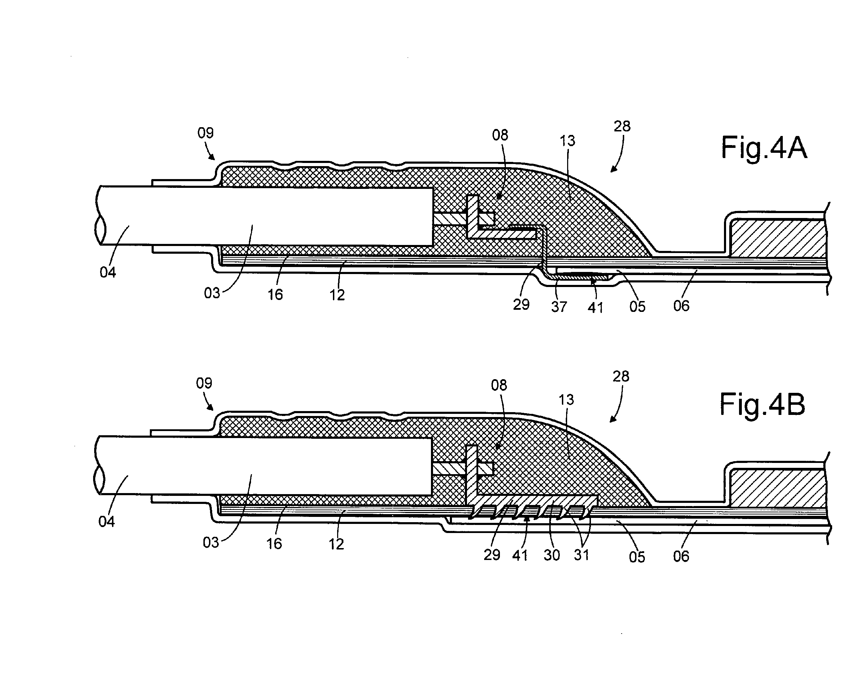

Die **FIGUREN 4A** und **4B** zeigen zwei Ausführungsformen des Formteils **13** in einer zweiten gemeinsamen Verbindungskomponente **28** in der Verbindungseinheit **02** im montierten Zustand. Neben dem Abschnitt **03** des Solarkabels **04** sind die elektrisch leitende Verbindung **08** und ein Leiterbandkontakt **29** (entsprechend zwei Leiterbandkontakte **29** bei einer Kontaktierung **41** von zwei Leiterbändern **06**) fest mit dem **Formteil 13** verbunden. Nach dem Aufsetzen des Formteils **13** auf die Modulfolie **12** werden nur noch die Leiterbänder **06** kontaktiert. Dazu kann der Leiterbandkontakt **29** gemäß **FIGUR 4A** als zusätzlicher Leiterbandabschnitt **37** ausgebildet sein, der aus der ebenen Unterseite **16** des Formteils **13** herausgeführt ist. Der zusätzliche Leiterbandabschnitt **37** wird dann noch durch die Modulfolie **12** hindurchgeführt und mit dem Leiterband **06** in einfacher Weise, beispielsweise durch Löten, dauerhaft elektrisch kontaktiert. Dabei liegt die Kontaktierung **41** im gezeigten Ausführungsbeispiel unterhalb des Formteils **13** und ist damit dauerhaft geschützt. Bei einer Anordnung der Kontaktierung **41** außerhalb des Formteils **13** muss diese zwingend in das Laminat **09** integriert sein. Alternativ kann der Leiterbandkontakt **29** gemäß **FIGUR 4B** auch als Kontaktplatte **30** ausgebildet sein, die in der ebenen Unterseite **16** des Formteils **13** angeordnet ist. Im gezeigten Ausführungsbeispiel weist die Kontaktpatte **30** Schneidkontakte **31** auf, die durch die Modulfolie **12** hindurch durch einfaches Aufsetzen des Formteils **13** auf die Modulfolie **12** das Leiterband **06** kontaktieren. Alternativ kann die Modulfolie **12** einen entsprechenden Ausschnitt aufweisen, insbesondere wenn Federkontakte an der Kontaktplatte **30** verwendet werden (in **FIGUR 4B** nicht dargestellt). Auch bei dieser Ausführungsform ist die Kontaktierung **41** gut durch das darüber liegende **Formteil 13** geschützt. Gut ist in beiden FIGUREN **4A, 4B** das Laminat **09** zu erkennen, das das **Formteil 13** einschließt. In den Figuren **4A**, **4B** nicht erwähnte Bezugszeichen sind den vorangehenden Figuren zu entnehmen.

In der **FIGUR 5** ist eine perspektivische Ansicht auf ein Solarmodul **01** dargestellt, bei dem es sich im gezeigten Ausführungsbeispiel um ein flexibles Solarmodul **40** mit Dünnschichtsolarzellen **32** handelt, das auf eine Dachbahn aufkaschiert sein kann (in der **FIGUR 5** nicht dargestellt). Zu erkennen ist die Anordnung der Verbindungseinheit **02** mit dem Formteil **13** in einem Randbereich **33**, sodass die Solarkabel **04** ungehindert ins Freie gelangen. Weiterhin ist das transparente Laminat **09**, das das gesamte Solarmodul **01** mit seinen Komponenten, insbesondere auch die Leiterbänder **04** (Zellverbinder **34** und Querverbinder **35**), luft- und wasserdicht einschließt, zu erkennen. Gestrichelt ist die elektrisch leitende Verbindung **08** zwischen Solarkabel **04** und Leiterbändern **06** angedeutet. Das gezeigte Solarmodul **01** verfügt über genau eine Verbindungseinheit **02**, die zwei elektrisch leitende Verbindungen **08** zwischen jeweils einem Solarkabel **04** und einem Leiterband **06** (hier Querverbinder **35**) umfasst. Neben den gezeigten Ausführungsbeispielen sind weitere Ausführungsformen bei der Erfindung ebenfalls ohne weiteres umsetzbar.

### BEZUGSZEICHENLISTE

- **01**: Solarmodul
- **02**: Verbindungseinheit
- **03**: Abschnitt von 04
- **04**: Solarkabel
- **05**: Abschnitt von 06
- **06**: Leiterband
- **07**: olarzelle
- **08**: elektrisch leitende Verbindung
- **09**: Laminat
- **10**: obere Laminatfolie
- **11**: untere Laminatfolie
- **12**: Modulfolie
- **13**: Formteil
- **14**: Rille
- **15**: Rippe
- **16**: ebene Unterseite von 13
- **17**: Nut
- **18**: erste Stirnseite von 13
- **19**: gemeinsame Nut
- **20**: Oberseite von 13
- **21**: undung von 20
- **22**: zweite Stirnseite von 13
- **23**: erste Verbindungskomponente
- **24**: abgewandtes Ende von 04
- **25**: Stecker
- **26**: Hohlraum
- **27**: Abdeckung
- **28**: zweite Verbindungskomponente
- **29**: Leiterbandkontakt
- **30**: Kontaktplatte
- **31**: Schneidkontakte
- **32**: Dünnschichtsolarzelle
- **33**: Randbereich von 01
- **34**: Zellverbinder
- **35**: Querverbinder
- **36**: Übergang zwischen 17,19
- **37**: Leiterbandabschnitt
- **38**: Niederhalter
- **39**: Abschrägung
- **40**: flexibles Solarmodul
- **41**: Kontaktierung 29 mit 05

## Patentansprüche

1. Solarmodul (01) mit zumindest einer Verbindungseinheit (02) mit zumindest einer elektrisch leitenden Verbindung (08) zwischen einem dem elektrischen Anschluss des Solarmoduls (01) dienenden Solarkabel (04) und einem mehrere Solarzellen (07) im Solarmodul (01) elektrisch leitend miteinander verbindenden Leiterband (06), wobei die Solarzellen (07) und das Leiterband (06) in ein biegsames Laminat (09) eingeschlossen sind,
**DADURCH GEKENNZEICHNET, DASS**
die Verbindungseinheit (02) ein biegsames Formteil (13) aufweist, das die zumindest eine elektrisch leitende Verbindung (08), einen Abschnitt (03) des Solarkabels (04) und einen Abschnitt (05) des Leiterbands (06), die jeweils an die zumindest eine elektrisch leitende Verbindung (08) anschließen, aufnimmt, und dass das Formteil (13) in das biegsame Laminat (09) formschlüssig eingeschlossen ist, wobei die Biegsamkeit des Formteils (13) an die Biegsamkeit des Laminats (09) in der Weise angepasst ist, dass Biegungen, denen das Laminat (09) unterworfen wird, in gleichem Maße auch von dem Formteil (13) ausgeführt werden.

2. Solarmodul (01) nach Anspruch 1,
**DADURCH GEKENNZEICHNET, DASS**
das Formteil (13) eine ebene Unterseite (16) als Auflagefläche im Solarmodul (01) aufweist.

3. Solarmodul (01) nach Anspruch 2,
**DADURCH GEKENNZEICHNET, DASS**
das Formteil (01) in seiner ebenen Unterseite (16) zumindest eine eingearbeitete Nut (17, 19) aufweist, in die die zumindest eine elektrisch leitende Verbindung (08), der Abschnitt (03) des Solarkabels (04) und der Abschnitt (05) des Leiterbands (06) eingelegt sind.

4. Solarmodul (01) nach Anspruch 3,
**DADURCH GEKENNZEICHNET, DASS**
das Formteil (13) im Bereich des Abschnitts (03) des Solarkabels (04) Niederhalter (38) aufweist, mit denen der Abschnitt (03) des Solarkabels (04) niedergedrückt wird, wobei die Niederhalter (38) aus quer zu der Nut (17) verlaufenden Rippen (15) gebildet sind.

5. Solarmodul (01) nach Anspruch 2,
**DADURCH GEKENNZEICHNET, DASS**
das Formteil (13) auf einer Seite den Abschnitt (03) des Solarkabels (04) umfasst und auf der anderen Seite in der ebenen Unterseite (16) zumindest eine gemeinsame Nut (19) aufweist, in die der Abschnitt (05) des Leiterbands (06) eingelegt ist, und die zumindest eine elektrisch leitende Verbindung (08) in einem Hohlraum (26) angeordnet ist, der sich von einer Oberseite (20) des Formteils (13) bis zur ebenen Unterseite (16) des Formteils (13) erstreckt, wobei der Hohlraum (26) auf der Oberseite (20) des Formteils (13) von einer Abdeckung (27) abgeschlossen ist, die vom Laminat (09) abgedeckt ist.

6. Solarmodul (01) nach Anspruch 1 oder 2,
**DADURCH GEKENNZEICHNET, DASS**
das Formteil (13) den Abschnitt (03) des Solarkabels (04), die zumindest eine elektrisch leitende Verbindung (08) und einen Leiterbandkontakt (29) umfasst, der mit der elektrisch leitenden Verbindung (08) und mit dem Leiterband (06) im Solarmodul (01) elektrisch leitend verbunden ist.

7. Solarmodul (01) nach Anspruch 6,
**DADURCH GEKENNZEICHNET, DASS**
der Leiterbandkontakt (29) von einem zusätzlichen Leiterbandabschnitt (37) gebildet ist, der aus der ebenen Unterseite (16) des Formteils (13) herausgeführt ist.

8. Solarmodul (01) nach Anspruch 7,
**DADURCH GEKENNZEICHNET, DASS**
der Leiterbandkontakt (29) von einer Kontaktplatte (30) gebildet ist, die in der ebenen Unterseite (16) des Formteils (13) angeordnet ist und Schneidkontakte (31) oder Federkontakte zu einer Kontaktierung (41) mit dem Leiterband (06) im Solarmodul (01) aufweist.

9. Solarmodul (01) nach zumindest einem der Ansprüche 1 bis 8,
**DADURCH GEKENNZEICHNET, DASS**
das Formteil (13) eine erste Stirnseite (18) aufweist, über die der Abschnitt (03) des Solarkabels (04) aus dem Formteil (13) herausgeführt ist und mit der es in einem Randbereich (33) des Solarmoduls (01) angeordnet ist.

10. Solarmodul (01) nach zumindest einem der Ansprüche 1 bis 9,
**DADURCH GEKENNZEICHNET, DASS**
das Formteil (13) eine zweite Stirnseite (22) mit einer Abschrägung (39) aufweist.

11. Solarmodul (01) nach zumindest einem der Ansprüche 1 bis 10,
**DADURCH GEKENNZEICHNET, DASS**
die Oberseite des Formteils eine Rundung (21) und/oder quer zum Abschnitt (03) des Solarkabels (04) verlaufende Rillen (14) aufweist.

12. Solarmodul (01) nach zumindest einem der Ansprüche 2 bis 11 **DADURCH GEKENNZEICHNET, DASS**
das Formteil (13) auf seiner ebenen Unterseite (16) eine Klebeschicht oder eine Laminierschicht aufweist.

13. Solarmodul (01) nach zumindest einem der Ansprüche 1 bis 12,
**DADURCH GEKENNZEICHNET, DASS**
das Formteil (13) als einstückiges Spritzgussteil aus einem Kunststoff ausgebildet ist.

14. Solarmodul (01) nach zumindest einem der Ansprüche 1 bis 13,
**DADURCH GEKENNZEICHNET, DASS**
genau eine Verbindungseinheit (02) mit zwei elektrisch leitenden Verbindungen (08) zwischen jeweils einem Solarkabel (04) und einem Leiterband (06) vorgesehen ist.

15. Solarmodul (01) nach zumindest einem der Ansprüche 1 bis 14,
**DADURCH GEKENNZEICHNET, DASS**
die Verbindungseinheit (02) in einem Randbereich (33) des Solarmoduls (01) angeordnet ist.
